# EUROPEAN PATENT APPLICATION

(11) **EP 2 437 100 A2**
(43) Date of publication of application: **04.04.2012**
(21) Application number: 10780717.4
(22) Date of filing: 04.05.2010
(51) Int. Cl.: G02F 1/133, H05B 33/02, G02F 1/1335

(54) **DISPLAY DEVICE**

(30) Priority: 29.05.2009 KR 20090047790
(71) Applicant: Neoviewkolon Co., Ltd., Chungcheongnam-Do 350-883 (KR)
(72) Inventor: PARK, Il Ho, Chungcheongnam-Do 350-752 (KR); IM, Woo Bin, Chungcheongnam-Do 350-809 (KR)
(74) Representative: Beck & Rössig European Patent Attorneys
(86) International application number: PCT/KR2010/002843
(87) International publication number: WO 2010/137806

(57) **Abstract**

Disclosed herein is a display device. A first display panel displays first information. A second display panel is selectively placed in a superimposed position, in which the second display panel is superimposed on the first display panel, and in a non-superimposed position, in which the second display panel is not superimposed on the first display panel, and displays second information. A first touch panel is disposed on the first display panel. One or more second touch panels are disposed on the second display panel or disposed on the both side surfaces of the second display panel in pairs. A control unit applies driving voltage to at least one of the first and second display panels based on a signal detected from at least one of the first and second touch panels depending on any one of the superimposed position and the non-superimposed position of the first and second display panels.

## Description

### [Technical Field]

The present invention relates generally to a display device, and, more particularly, to a display device for separately displaying information on the display panels of a dual display panel in response to a signal detected from a touch panel.

### [Background Art]

Recently, display devices for displaying various types of information are applied to both large-sized electronic equipment, such as Televisions (TV), and small-sized electronic equipment, such as Portable Media Players (PMP), Moving Picture Experts Group Audio Layer-3 (MP3), and mobile phones.

In particular, display devices applied to mobile communication terminals, such as mobile phones, include a Liquid Crystal Display (LCD), an Organic Light Emitting Diode (OLED), and Electronic-paper (E-paper).

Meanwhile, in the recent industrial trend for such a display device, a touch panel is used as an input manner of applying signals in order to display information on the display device. The display device having a touch panel is divided into a full-touch functional display device including a single display panel and a touch panel, and a display device including a touch panel, a main display panel, and a sub display panel in order to reduce power consumption.

Here, the sub display panel displays simple sub information, such as the remaining battery capacity, the current time, the date, and a user's name.

However, the display device including the main display panel and the sub display panel has an advantage of low power consumption compared with the full-touch functional display device but has the disadvantage of being structurally limited because a separate arrangement space is necessary to include the sub display panel. Therefore, a technique is required to minimize the thickness of the sub display panel so that the entire display device can be slim and compact.

Further, the function of the sub display panel for displaying the above-described simple sub information, such as the remaining battery capacity, the current time, the date, and a user's name, requires improving. That is, in order to increase the convenience to users, the necessity for a dual-type display device for separately displaying information on a main display panel and on a sub display panel in response to a signal detected from a touch panel has been on the rise.

### [Disclosure]

### [Technical Problem]

Accordingly, the present invention has been made keeping in mind the above problems occurring in the prior art, and an object of the present invention is to provide a display device which makes improvements in spatial limitations in order to include a separate sub display panel, so that the display device can be slim and compact.

Another object of the present invention is to provide a display device which makes improvements in the structure and control method thereof in order to drive two display panels separately in response to a signal detected from a touch panel.

### [Technical Solution]

In order to accomplish the above object, the present invention provides a display device including: a first display panel configured to display first information; a second display panel selectively placed in a superimposed position, in which the second display panel is superimposed on the first display panel, and in a non-superimposed position, in which the second display panel is not superimposed on the first display panel, and configured to display second information; a first touch panel disposed on the first display panel; one or more second touch panels disposed on the second display panel or disposed on both side surfaces of the second display panel in pairs; and a control unit configured to apply driving voltage to at least one of the first and second display panels based on a signal detected from at least one of the first and second touch panels depending on any one of the superimposed position and the non-superimposed position of the first and second display panels.

Here, the first display panel includes an Organic Light-Emitting Diode (OLED) panel.

The first display panel includes any one of a Liquid Crystal Display (LCD) panel and Electronic-paper (E-Paper).

Further, the second display panel includes an OLED panel.

The OLED panel includes a Transparent Organic Light-Emitting Diode (TOLED) panel.

The TOLED panel includes: a substrate; a first electrode formed on the substrate; an organic layer formed on the first electrode; a second electrode formed on the organic layer; and a transparent layer formed between the organic layer and the second electrode and/or on the second electrode, and configured to include any one selected from a group consisting of oxides, nitrides, salts, and mixtures thereof. Here, the oxides comprise MoO₃, ITO, IZO, 10, ZnO, TO, TiO₂, SiO₂, WO₃, AL₂O₃, Cr₂O₃, TeO₂ and SrO₂.

The nitrides include Si₃N₄ and AIN.

The salts include Cs₂CO₃, Li₂CO₃, K₂CO₃, Na₂CO₃, LiF, CsF, and ZnSe.

The thickness of the transparent layer is equal to or greater than 0.1 nm and less than 100 nm.

The organic layer includes an electron transporting layer doped with any one selected from a group consisting of low-work-function metals and mixtures thereof in order to facilitate injection of electrons from the second electrode.

The low-work-function metals include Cs, Li, Na, K, and Ca.

The mixtures thereof include Li-Al, LiF, CsF, and Cs₂CO₃.

Preferably, the TOLED panel exhibits a transmittance ranging from 70 to 99% depending on wavelength (nm).

The second display panel moves on the first display panel in a sliding manner between the superimposed position and the non-superimposed position. Preferably, the control unit applies the driving voltage to the first display panel based on the signal detected from the second touch panel when the first and second display panels are placed in the superimposed position. Meanwhile, the control unit applies the driving voltage to the first display panel based on the signal detected from the first touch panel and applies the driving voltage to the second display panel based on the signal detected from the second touch panel when the first and second display panels are placed in the non-superimposed position. A brightness measurement sensor for detecting intensity of an outside illumination is further included, and the control unit controls the driving voltage based on a signal detected from the brightness measurement sensor so that the brightness of any one of the first and second display panels is adjusted. In order to accomplish the above object, the present invention provides a display device including: a first display panel configured to display first information; a second display panel selectively placed in a superimposed position, in which the second display panel is superimposed on the first display panel, and a non-superimposed position, in which the second display panel is not superimposed on the first display panel, and configured to display second information; a touch panel disposed on the second display panel; and a control unit configured to, when the first and the second display panels are placed in any one of the superimposed position and the non-superimposed position, selectively apply driving voltage to the first and second display panels based on a signal detected from the touch panel. Here, the first display panel includes any one of an OLED panel, an LCD panel, and E-Paper; and the second display panel comprises the OLED panel. Further, the OLED panel includes a TOLED panel. The second display panel moves on the first display panel in a sliding manner between the superimposed position and the non-superimposed position. The second display panel moves relative to the first display panel in a rotating manner between the superimposed position and the non-superimposed position. The control unit applies the driving voltage to the first display panel based on the signal detected from the touch panel when the first and second display panels are placed in the superimposed position. Meanwhile, the control unit applies the driving voltage to the second display panel based on the signal detected from the touch panel when the first and second display panels are placed in the non-superimposed position. A brightness measurement sensor for detecting intensity of an outside illumination is further included, and the control unit controls the driving voltage based on a signal detected from the brightness measurement sensor so that brightness of at least any one of the first and second display panels is adjusted.

Further, in order to accomplish the above object, the present invention provides a display device including: a first display panel configured to display first information; a second display panel selectively placed in a superimposed position, in which the second display panel is superimposed on the first display panel, and a non-superimposed position, in which the second display panel is not superimposed on the first display panel, and configured to display second information; a first touch panel disposed on the first display panel; a second touch panel disposed on one surface of the second display panel which is rotated relatively to the first touch panel; and a control unit configured to selectively apply driving voltage to the first and second display panels based on a signal detected from the first or second touch panels.

The first display panel includes any one of an OLED panel, an LCD panel, and E-paper; and the second display panel includes the OLED panel.

The OLED panel includes a TOLED panel.

The second display panel moves on the first display panel in a sliding manner between the superimposed position and the non-superimposed position.

Meanwhile, the second display panel moves relative to the first display panel in a rotating manner between the superimposed position and the non-superimposed position.

Preferably, the control unit applies the driving voltage to the first display panel based on the signal detected from the first touch panel and applies the driving voltage to the second display panel based on the signal detected from the second touch panel when the first and second display panels are placed in the non-superimposed position.

A brightness measurement sensor for detecting intensity of an outside illumination is further included, and the control unit controls the driving voltage based on a signal detected from the brightness measurement sensor so that brightness of any one of the first and second display panels is adjusted.

### [Advantageous Effects]

Therefore, according to the invention, a TOLED panel is used as any one of display panels of the dual display panel, so that the display device which is slim and compact is provided.

Further, each of the display panels of the dual display panel includes a touch panel, and the display panels are connected to be mutually moved, so that different information can be displayed on the separate display panels, thereby increasing the use of the product.

Furthermore, information is separately displayed on different display panels depending on the superimposed position and non-superimposed position of the dual display panel, thereby increasing the use of the product.

Further, in the a TOLED panel used as the display panel, the transparent layer which is made of any one selected from a group consisting of oxides, nitrides, salts, and the mixtures thereof is formed between the organic layer and the second electrode or formed on the top of the second electrode, so that a display device capable of realizing double-sided light emission and improving transmittance is provided.

The transparent layer is made of any one selected from a group consisting of oxides, nitrides, salts, and the mixtures thereof, so that the increase in the internal resistance of the second electrode can be prevented, thereby improving transmittance and electrical performance of products.

### [Description of Drawings]

FIG. 1 is block diagram showing the control of a display device according to an embodiment of the present invention;
FIG. 2 is a perspective view showing a display device according to a first embodiment of the present invention;
FIG. 3 is a schematic view showing a structure in which the first display panel and second display panel of the display device according to the first embodiment of the present invention are in a superimposed position;
FIG. 4 is a schematic view showing a structure in which the second display panel moves on the first display panel in a sliding manner, the second display panel and the first display panel being shown in FIG. 3;
FIG. 5 is a schematic view showing a structure in which a second display panel moves against a first display panel in a rotating manner, the second display panel and the first display panel being included in a display device according to a second embodiment of the present invention;
FIG. 6 is a flowchart showing the control of the display device according to the first and second embodiments of the present invention;
FIG. 7 is a schematic view showing a structure in which a second display panel moves against a first display panel in a rotating manner, the second display panel and the first display panel being included in a display device according to a third embodiment of the present invention;
FIG. 8 is a flowchart showing the control of the display device according to the third embodiment of the present invention;
FIG. 9 is a schematic view showing a structure in which the first display panel and second display panel of a display device according to a fourth embodiment of the present invention are in a superimposed position;
FIG. 10 is a schematic view showing a structure in which the second display panel moves on the first display panel in a sliding manner, the second display panel and the first display panel being shown in FIG. 9;
FIG. 11 is a flowchart showing the control of the display device according to the fourth embodiment of the present invention;
FIG. 12 is a view showing the cross section of the second display panel according to the embodiment of the present invention;
FIG. 13 is a graph showing transmittance of the transparent layer of the second display panel of FIG. 12;
FIG. 14 is a graph showing luminance of the transparent layer of the second display panel of FIG. 12; and
FIG. 15 is a graph showing transmittance when a transparent layer is formed of any one selected from a group consisting of oxides, salts, and mixtures thereof on the second display panel of FIG. 12.

### <Description of the Reference Numerals in the Drawings>

| | |
|---|---|
| 10 : display panel | 12 : first display panel |
| 12' : first display panel | 14 : second display panel |
| 14' : second display panel | 50: touch panel |
| 52 : first touch panel | 54 : second touch panel |
| 70 : brightness measurement sensor | |
| 90 : control unit 100 : substrate | 130 : first electrode |
| 150 : second electrode | 170 : organic layer |
| 172 : Hole Injection Layer | 174 : Hole Transporting Layer |
| 176 : Emissive Layer | 178 : Electron Transporting Layer |
| 179 : Electron Injection Layer | 190 : transparent layer |
| 191 : first transparent layer | 192 : second transparent layer |

### [Best Mode]

A display device according to an embodiment of the present invention will be described in detail below by referring to the accompanying drawings.

Before the description, when it is determined that the detailed descriptions of well-known techniques related to the present invention or detailed description of construction in the embodiment of the present invention would obscure the gist of the present invention, they will be omitted.

Further, it is noted that, in the first to fourth embodiments of the present invention, different reference numerals are used for a first display panel and a second display panel in the first to third embodiments in which a plurality of touch panels are used and in the fourth embodiment in which a single touch panel is used.

Further, it is noted that the same reference numeral is used for a second touch panel through the first to third embodiments of the present invention regardless of the arrangement location and arrangement number thereof.

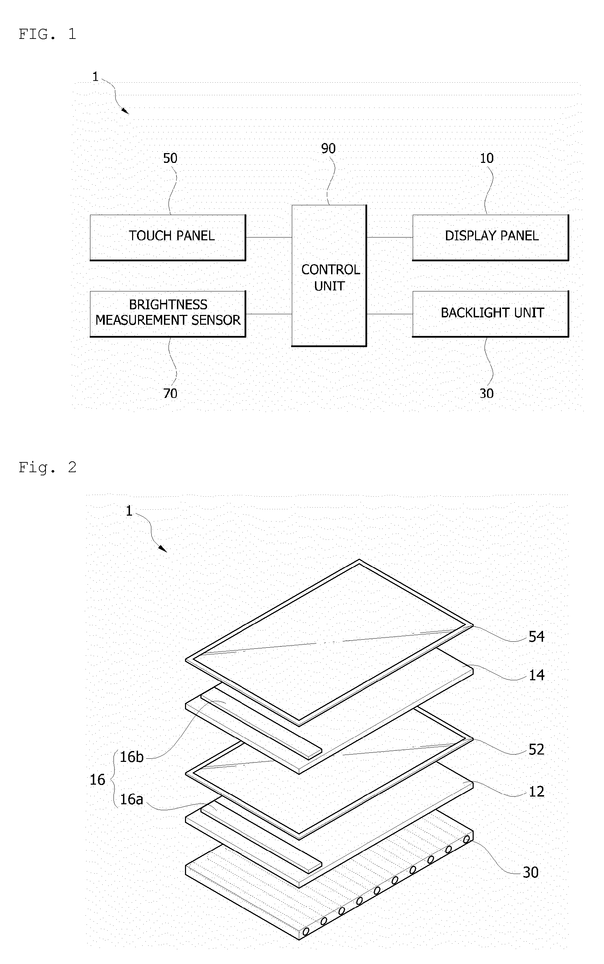

FIG. 1 is block diagram showing the control of a display device according to the first to fourth embodiments of the present invention. Although the touch panel and display panel of FIG. 1 comprehensively implement the first to fourth embodiments of the present invention, the detailed description thereof will be separately performed.

As shown in FIG. 1, the display device 1 according to the embodiments of the present invention includes a display panel 10, a touch panel 50, a backlight unit 30, a brightness measurement sensor 70, and a control unit 90.

The display panel 10 of the display device 1 according to a first embodiment of the present invention includes a first display panel 12, a second display panel 14, and a driver IC 16, as shown in FIG. 2.

Any one of an Organic Light-Emitting Diode (OLED) panel, a liquid crystal display (LCD) panel and Electronic paper (E-paper) is used as the first display panel 12.

The OLED panel, used as the first display panel 12, will be described in detail when the second display panel 14 will be described. Hereinafter, the first display panel 12 which employs a liquid crystal panel or E-paper will be described.

A liquid crystal panel, used as the first display panel 12, displays characters, numbers, and icons by selectively passing light, radiated from the backlight unit 30 provided under the first display panel 12, using dielectric anisotropy in which the alignment direction of liquid crystal changes depending on voltage applied from outside. The backlight unit 30 includes a Cold Cathode Fluorescent Lamp (CCFL), an External Electrode Fluorescent Lamp (EEFL), a Light-Emitting Diode (LED), and a Flat Fluorescent Lamp (FFL). Since the liquid crystal panel can be understood using well-known techniques, the detailed description thereof will be omitted.

E-paper, used as the first display panel 12, uses the characteristics of ordinary ink on paper. E-paper displays information using reflection light like ordinary paper. Since the E-paper can be understood using well-known techniques like the liquid crystal panel, the detailed description thereof will be omitted.

A liquid crystal panel is used as the first display panel 12 of the display device 1 according to the embodiment of the present invention from between the liquid crystal panel and the E-paper. Of course, since the liquid crystal panel is used as the first display panel 12, the backlight unit 30 for radiating light is mounted on one side of the first display panel 12.

A driving Integrated Circuit (IC) 16a for the first display panel, which is electrically connected to the control unit 90 which will be described later, is mounted on the first display panel 12. First information is displayed on the first display panel 12 in such a way that the driver IC 16a for the first display panel is operated under the control of the control unit 90. Here, the first information is referred to as main information. Therefore, it can be understood that the first display panel 12 is used as a main display panel. For example, when the first display panel 12 is applied to a mobile communication terminal, such as a mobile phone, and portable equipment, such as a PMP, the first display panel 12 displays characters, numbers, icons, and moving pictures, the resolution of which is higher than that of information to be displayed on a second display panel 14 which will be described later.

An OLED panel is used as the second display panel 14. The OLED panel is the self luminous phenomenon in which electrons and holes (particles each having an electric charge corresponding to electron) injected from cathode and anode are electrically combined with each other in organic matter, thereby emitting light, or is an organic light-emitting diode which uses the self luminous phenomenon. Since the OLED panel can be understood using well-known techniques, the detailed description thereof will be omitted.

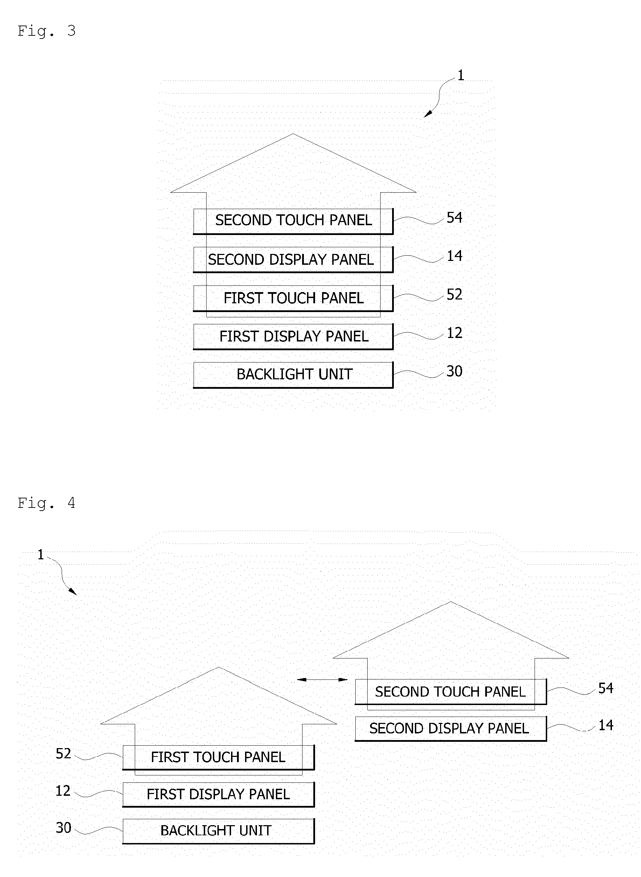

The second display panel 14 of the present invention includes a Transparent Organic Light Emitting Diode (TOLED) panel of the OLED panel. The TOLED panel is a transparent OLED panel manufactured by coating a hole transporting layer, an emissive layer, and an electron transporting layer on the transparent positive electrode of Indium-Tin Oxide (ITO), thinly coating a transparent negative electrode thereon, and coating an ITO film used for compensating for conductivity, functioning as a protection layer, and maintaining transparency thereon. As shown in FIG. 3, the TOLED panel enables the first information displayed on the first display panel 12 to pass therethrough. Further, the configuration and features of the TOLED panel used as the display panel 10 of the present invention will be described after the first to fourth embodiments of the present invention have been described.

A driver IC 16b for the second display panel, which is electrically connected to the control unit 90, is mounted on the second display panel 14. Second information is displayed on the second display panel 14 in such a way that the driver IC 16b for the second display panel is operated under the control of the control unit 90. The second display panel 14 of the present invention is used as a sub display panel, contrary to the first display panel 12 used as the main display panel. Therefore, the second information displayed on the second display panel 14 can be referred to as sub information, the resolution of which is lower than that of the first information displayed on the first display panel 12, and which includes battery remaining capacity, current time, the weather, and a user's name. However, unlike the embodiment of the present invention, the second information displayed on the second display panel 14 can have the same resolution as the first information displayed on the first display panel 12, and various types of information can be displayed as the second information.

Since the thinly-coated TOLED panel is used as the second display panel 14, the thickness of the dual display panel 10 can be minimized when the dual display panel 10 is used, so that the display device 1 can be slim and compact.

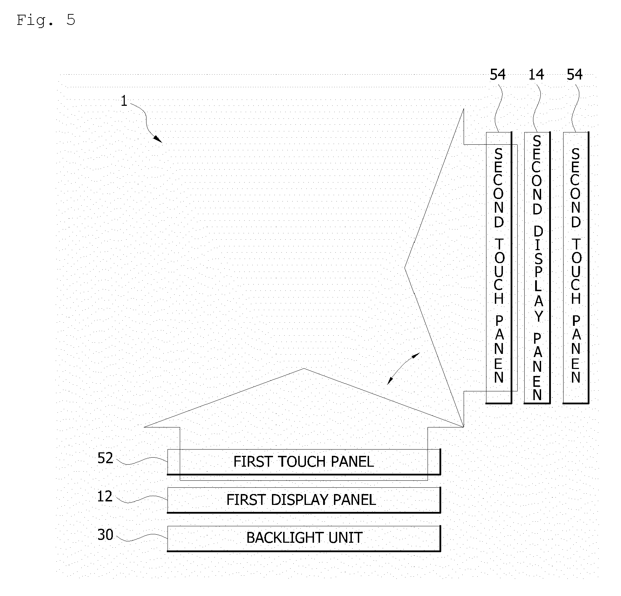

Meanwhile, as shown in FIGS. 4 and 5, the second display panel 14 of the present invention is selectively placed in a superimposed position, in which the second display panel 14 is superimposed on the first display panel 12, and in a non-superimposed position, in which the second display panel 14 is not superimposed on the first display panel 12. Here, the second display panel 14 of the display device 1 according to the first embodiment of the present invention of FIG. 4 moves on the first display panel 12 in a sliding manner between the superimposed position, in which the second display panel 14 is superimposed on the first display panel 12, and the non-superimposed position, in which the second display panel 14 is not superimposed on the first display panel 12. Of course, even not shown in the drawing, the second display panel 14 can move against the first display panel 12 in a rotating manner.

Meanwhile, FIG. 5 representatively shows an example of the second display panel 14 of the display device 1 according to the second embodiment of the present invention being selectively placed in the superimposed position and the non-superimposed position for the first display panel 12. FIG. 5 shows movement in a rotating manner from between movement in a sliding manner and movement in a rotating manner. Here, even though the number and arrangement locations of the second touch panel of FIG. 5 are different from those of FIGS. 2 and 3, the spirit of the present invention is the same in FIGS. 2, 3, and 5.

In the display device according to the second embodiment of the present invention, a pair of second touch panels 54 are disposed on both surfaces of the second display panel 14 interposed therebetween, unlike the first embodiment of the present invention.

Due to the disposition of the second touch panels 54, although the same function is performed in the superimposed position of the first display panel 12 and the second display panel 14 as that of the first embodiment of the present invention, the function of the second embodiment is implemented by a signal detected from one of the second touch panels 54, which is rotated relatively to the first touch panel 52, in the non-superimposed position of the first display panel 12 and the second display panel 14,.

Although the above-described first display panel 12 and second display panel 14 are respectively described as the main display panel and the sub display panel in the embodiment of the present invention, the first display panel 12 and the second display panel 14 can be displaced in such a way that the first display panel 12 and the second display panel 14 are respectively used as the sub display panel and the main display panel, contrary to the embodiment of the present invention.

Next, the touch panel 50 is an input device for generating electric signals using a capacitive overlay in which an analyzer is pressed by a pen or a hand, a conductive film is pressed by force applied to the analyzer and comes in contact with X-Y electrode patterns, thereby detecting the difference in the voltage of the X-Y electrode patterns. Since the touch panel 50 can be understood using well-known techniques, the detailed description thereof is omitted. The touch panel 50 according to the first and second embodiments of the present invention includes the first touch panel 52 disposed on the first display panel 12, the second touch panel 54 disposed on the second display panel 14, and the pair of second touch panels 54 disposed on both surfaces of the second display panel 14.

The first touch panel 52 is placed on and coupled to the first display panel 12. A signal detected from the first touch panel 52 according to the embodiment of the present invention is transmitted to the control unit 90 so that first information is displayed on the first display panel 12. Of course, in order to apply a signal to the first touch panel 52, the first display panel 12 and the second display panel 14 should be placed in the non-superimposed position.

The second touch panel 54 is placed on and coupled to the second display panel 14. Here, the second touch panel 54 according to the first embodiment of the present invention is disposed on the second display panel, and the second touch panels 54 according to the second embodiment of the present invention are disposed on the both side surfaces of the second display panel 14.

When the first display panel 12 and the second display panel 14 are placed in the superimposed position, the signal detected from the second touch panel 54 is transmitted to the control unit 90 so that the first information is displayed on the first display panel 12. Meanwhile, when the first display panel 12 and the second display panel 14 are placed in the non-superimposed position, the signal detected from the second touch panel 54 is transmitted to the control unit 90 so that the second information is displayed on the second display panel 14. That is, according to the superimposed position or non-superimposed position of the first display panel 12 and the second display panel 14, the first or second information is displayed in response to the signal detected from the second touch panel 54 and transmitted to the control unit 90.

When the first display panel 12 and the second display panel 14 are placed in the superimposed position, the signal detected from the second touch panel 54 is provided so that the first information is displayed on the first display panel 12. However, when the first display panel 12 and the second display panel 14 are placed in the non-superimposed position, the signal detected from the second touch panel 54 is provided so that the second information is displayed on the second display panel 14.

Next, the brightness measurement sensor 70 measures the brightness of use environment so as to improve the visibility of information to be displayed on at least one of the first display panel 12 and the second display panel 14 depending on the use environment of the display device 1. A signal detected by the brightness measurement sensor 70 is transmitted to the control unit 90. The control unit 90 controls the brightness of the display panel 10 by stages based on the signal. A control method performed by the brightness measurement sensor 70 will be described in detail when the control unit 90, which will be described later, is described.

The control unit 90 applies driving voltage into the display panel 10 based on the signal detected from the touch panel 50. When the first display panel 12 and the second display panel 14 are placed in the superimposed position in which the second display panel 14 is superimposed on the first display panel 12, the control unit 90 applies the driving voltage so that the first information is displayed on the first display panel 12 based on the signal detected by the second touch panel 54. Meanwhile, when the first display panel 12 and the second display panel 14 are placed in the non-superimposed position in which the second display panel 14 is not superimposed on the first display panel 12 due to moving in a sliding manner or in a rotating manner, the control unit 90 applies the driving voltage based on the signal detected from the first touch panel 52 so that the first information is displayed on the first display panel 12, and applies the driving voltage based on the signal detected from the second touch panel 54 so that the second information is displayed on the second display panel 14.

Here, in order that the control unit 90 can distinguish the superimposed position form the non-superimposed position and can control the approval of the driving voltage to the display panel 10, it is preferable that a sensor, such as a location detection sensor (not shown) capable of detecting the superimposed position and the non-superimposed position, be provided. Of course, any well-known sensor can be applied if the sensor can detect the locations of the first display panel 12 and the second display panel 14.

The control unit 90 controls the driving voltage applied to the display panel 10 so that the brightness level of the display panel 10 can be changed based on the signal from the brightness measurement sensor 70. For example, the control unit 90 controls the driving voltage based on the signal from the brightness measurement sensor 70 so that the brightness of the display panel 10 becomes high if the use environment of the display device 1 is bright, or the brightness of the display panel 10 becomes low if the use environment of the display device 1 is dark.

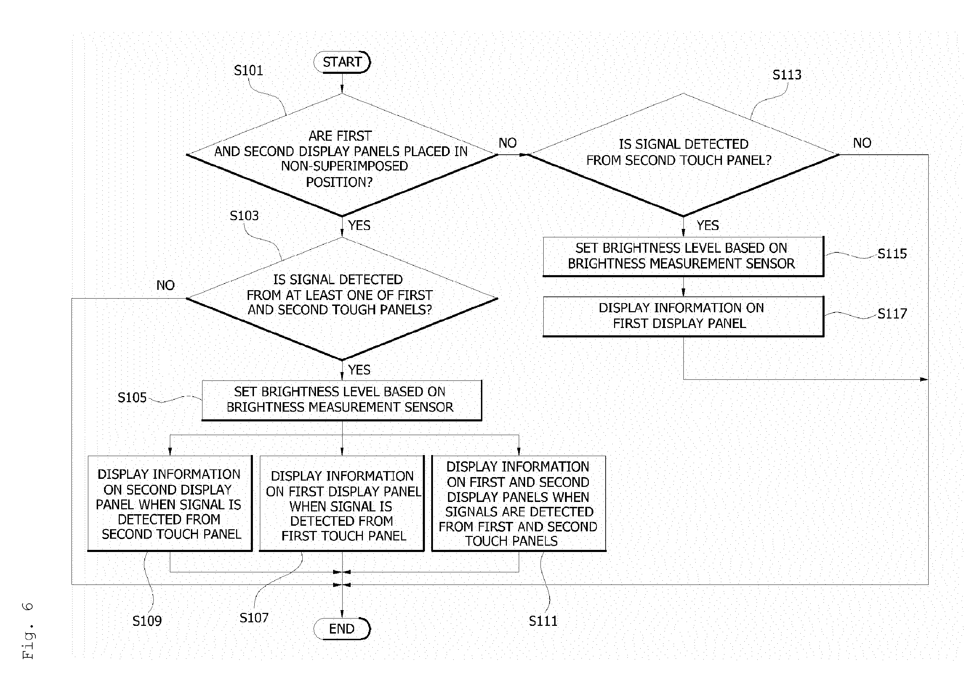

With the above-described configuration, a method of controlling the display device 1 according to the first and second embodiments of the present invention will be described in detail by referring to FIG. 6. The control method of FIG. 6 will be described using the fact that the second display panel 14 moves on the first display panel 12 in a sliding manner by referring to FIG. 4 as a representative example of the first and second embodiments of the present invention. However, the control method below can be applied to the display device according to the first and second embodiments of the present invention.

First, it is determined whether the first display panel 12 and the second display panel 14 are placed in the non-superimposed position at step S101. If it is determined that the second display panel 14 is placed in the non-superimposed position for the first display panel 12, it is determined whether a signal is detected from at least one of the first touch panel 52 and the second touch panel 54 at step S103.

If a signal is detected from at least one of the first touch panel 52 and the second touch panel 54, the brightness level of the display panel 10 is set based on a signal detected by the brightness measurement sensor 70 at step S105.

If it is determined that a signal is detected from the first touch panel 52 at step S103, driving voltage is applied so that first information is displayed on the first display panel 12 at step S 107. Meanwhile, if it is determined that a signal is detected from the second touch panel 54 at step S103, driving voltage is applied so that second information is displayed on the second display panel 14 at step S109. If it is determined that signals are detected from both the first touch panel 52 and the second touch panel 54 at step S103, driving voltage is applied so that the first information and the second information are displayed on the first display panel 12 and the second display panel 14, respectively, at step S111.

If it is determined that the first display panel 12 and the second display panel 14 are not placed in the non-superimposed position at step S101, that is, it is determined that the first display panel 12 and the second display panel 14 are placed in the superimposed position, it is determined whether a signal is detected from the second touch panel 54 at step S 113.

If it is determined that a signal is detected from the second touch panel 54, the brightness level of the display panel 10 is set based on the signal detected by the brightness measurement sensor 70 at step S 115. Thereafter, driving voltage is applied so that first information is displayed on the first display panel 12 based on the signal from the second touch panel 54 at step S 117.

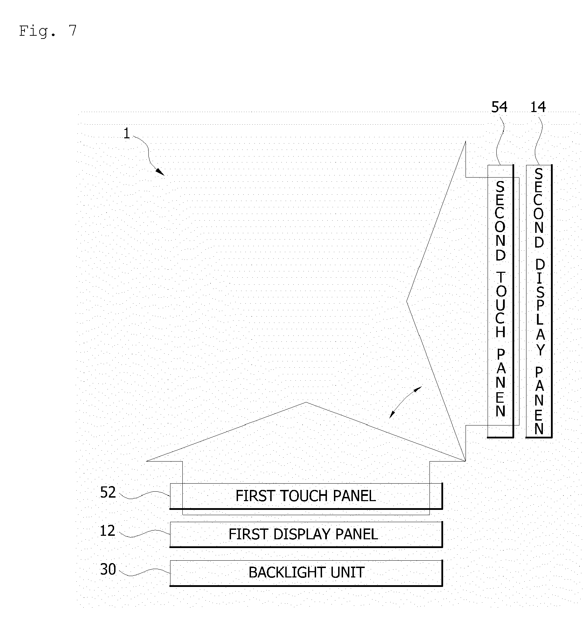

Next, although, as shown in FIG. 7, the configuration of a display device according to a third embodiment of the present invention is the same as that of the display device 1 according to the above-described first embodiment of the present invention, the second touch panel 54 is disposed on the second display panel 14 so that the second touch panel 54 is rotated relatively to the first touch panel 52 unlike the first embodiment of the present invention. Here, since the configuration of the display device 1 has been described above, only the part of the configuration of the display device according to the third embodiment of the present invention, which is different from the configuration of the first embodiment of the present invention, will be described.

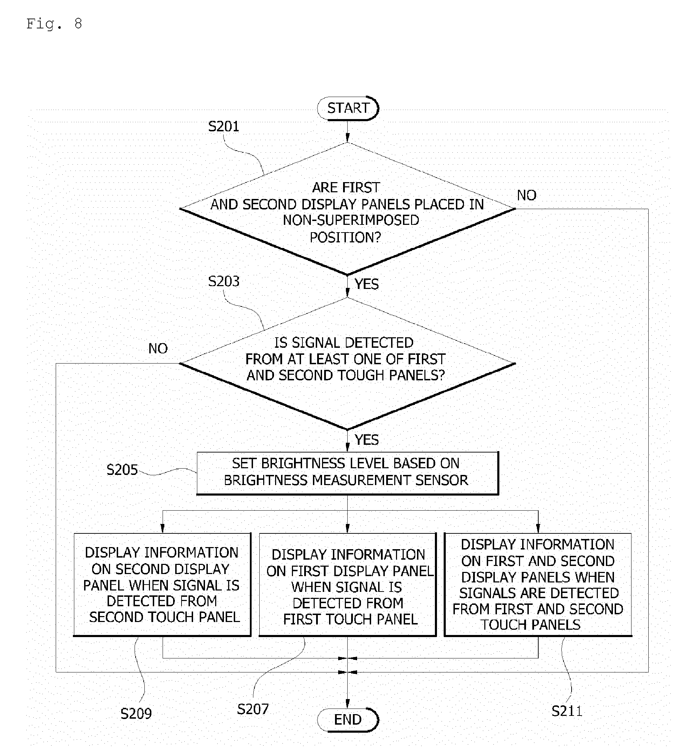

As shown in FIG. 8, a flowchart showing the control of the display device according to the third embodiment of the present invention is similar to those of the first and second embodiments in the non-superimposed position.

That is, it is determined whether the first display panel 12 and the second display panel 14 are placed in a non-superimposed position at step S201. If it is determined that the second display panel 14 is placed in the non-superimposed position for the first display panel 12, it is determined whether a signal is detected from at least one of the first touch panel 52 and the second touch panel 54 at step S203.

If a signal is detected from at least one of the first touch panel 52 and the second touch panel 54, the brightness level of the display panel 10 is set based on a signal detected by the brightness measurement sensor 70 at step S205.

If it is determined that a signal is detected from the first touch panel 52 at step S203, driving voltage is applied so that first information is displayed on the first display panel 12 at step S207. Meanwhile, if it is determined that a signal is detected from the second touch panel 54 at step S203, driving voltage is applied so that second information is displayed on the second display panel 14 at step S209. If it is determined that signals are detected from both the first touch panel 52 and the second touch panel 54 at step S203, driving voltage is applied so that the first information and the second information are displayed on the first display panel 12 and the second display panel 14, respectively, at step S211.

If it is determined that the first display panel 12 and the second display panel 14 are not placed in the non-superimposed position at step S201, that is, the first display panel 12 and the second display panel 14 are placed in the superimposed position, driving voltage used to display information on the first or second display panel cannot be applied since the first touch panel or the second touch panel is not exposed to the outside.

Meanwhile, like the first embodiment of the present invention, a display device 1 according to a fourth embodiment of the present invention includes a display panel 10, a touch panel 50, a backlight unit 30, a brightness measurement sensor 70, and a control unit 90. However, unlike the first embodiment of the present invention, the touch panel 50 of the display device 1 according to the fourth embodiment of the present invention includes only a second touch panel 54 (hereinafter, referred to as a 'touch panel' in the description according to the fourth embodiment of the present invention).

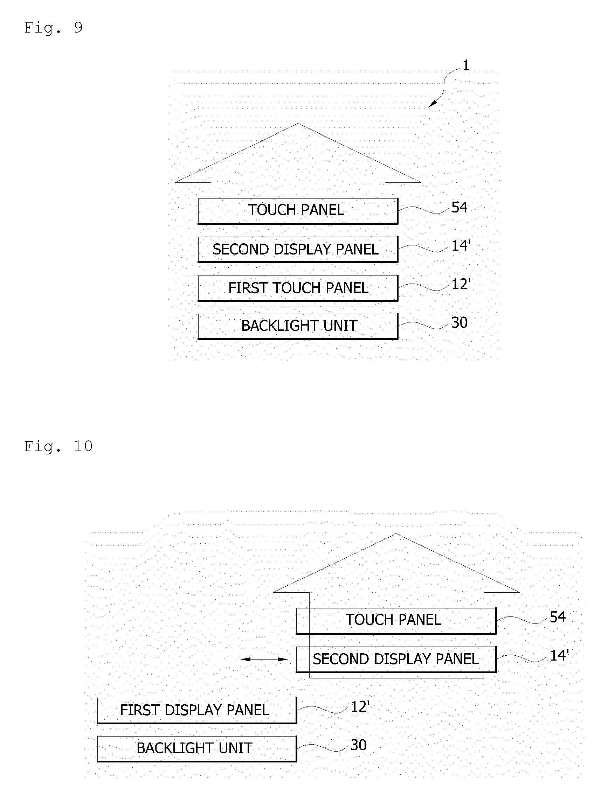

As shown in FIGS. 9 and 10, the display device 1 according to the fourth embodiment of the present invention applies driving voltage so that first information is displayed on a first display panel 12' based on a signal detected from the touch panel 50 in the superimposed position of the first display panel 12' and a second display panel 14'. Meanwhile, the display device 1 applies driving voltage so that second information is displayed on the second display panel 14' based on the signal detected from the touch panel 50 in the non-superimposed position of the first display panel 12' and the second display panel 14'

That is, when the first display panel 12' and the second display panel 14' are placed in the superimposed position or in the non-superimposed position, the display device 1 according to the fourth embodiment of the present invention applies driving voltage so that the first or second information is displayed on the first display panel 12' or the second display panel 14' based on the signal detected from the touch panel 50.

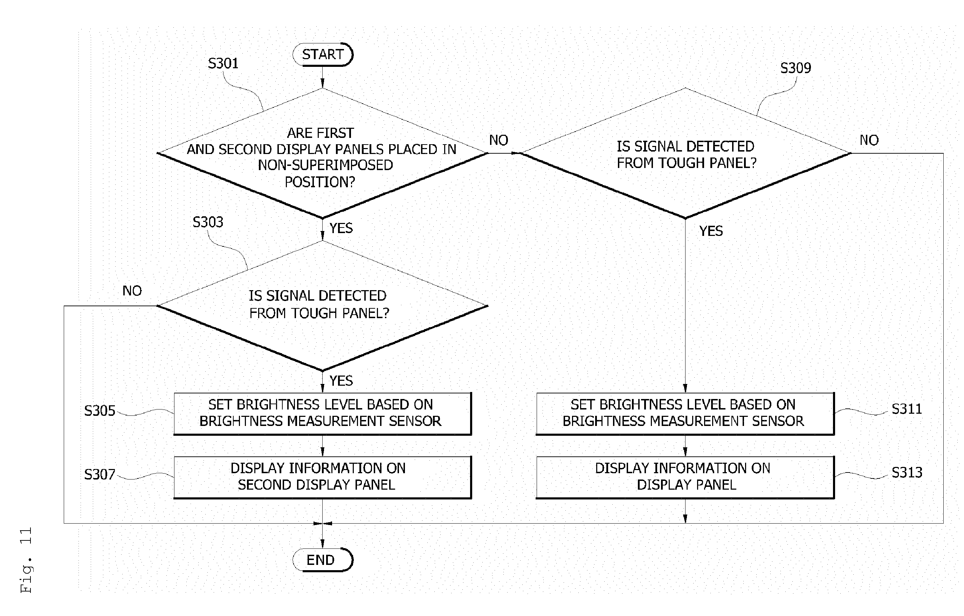

With the above-described configuration, the control method of the display device 1 according to the fourth embodiment of the present invention will be described in detail by referring to FIG. 11. In the description of the control method of the display device 1 according to the fourth embodiment of the present invention, the first display panel 12' and the second display panel 14' are connected to each other so that they can move in a sliding manner like the first embodiment of the present invention. Of course, even though not shown in the drawing, the display device 1 according to the fourth embodiment of the present invention may have the first display panel 12' and the second display panel 14' which are connected with each other so that they can move in a rotating manner.

First, it is determined whether the first display panel 12' and the second display panel 14' are placed in a non-superimposed position at step S301. If it is determined that the first display panel 12' and the second display panel 14' are placed in the non-superimposed position, it is determined whether a signal is detected from the touch panel 50 at step S303.

If it is determined that a signal is detected from the touch panel 50, the brightness level of the display panel 10 is set based on a signal detected by the brightness measurement sensor 70 at step S305. Thereafter, driving voltage is applied so that second information is displayed on the second display panel 14' based on the signal detected from touch panel 50 at step S307.

Meanwhile, it is determined that the first display panel 12' and the second display panel 14' are placed not in the non-superimposed position but in the superimposed position at step S301, it is determined whether a signal is detected from the touch panel 50 at step S309.

If it is determined that a signal is detected from the touch panel 50, the brightness level of the display panel 10 is set based on the signal detected by the brightness measurement sensor 70 at step S311. Thereafter, driving voltage is applied so that first information is displayed on the first display panel 12' based on the signal detected from touch panel 50 at step S313.

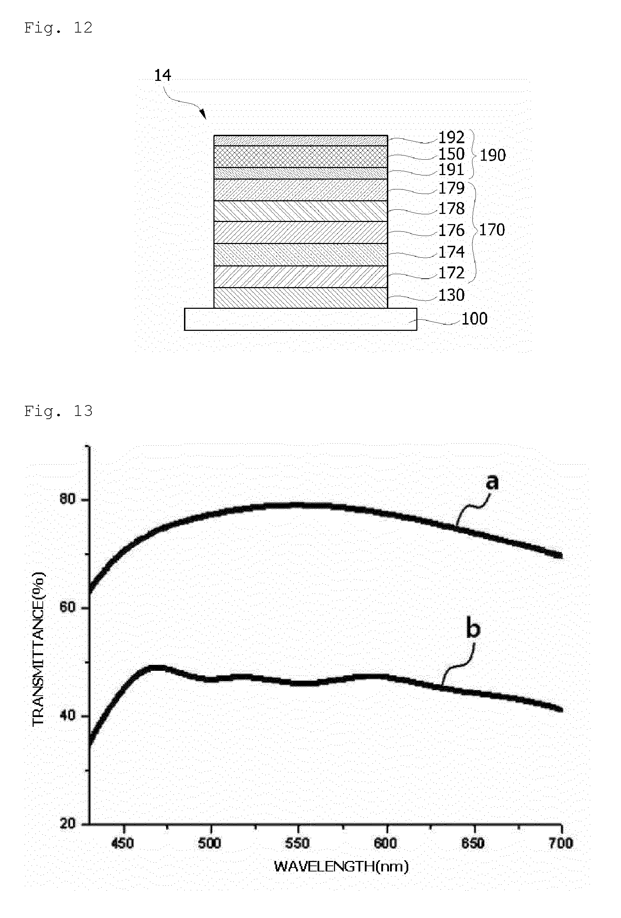

Next, the TOLED panel, used as the display panel of the present invention, includes a substrate 100, a first electrode 130, a second electrode 150, an organic layer 170, and a transparent layer 190, as shown in FIG. 12.

The substrate 100 supports the first electrode 130, the second electrode 150, the organic layer 170, and the transparent layer 190. The substrate 100 is made of glass or plastic material having transparency so that emitted light can pass through the substrate 100.

The first electrode 130 is commonly referred to as a lower electrode, and is formed on the substrate 100. The first electrode 130 is an anode, that is, a positive (+) electrode, and is formed on the substrate 100 using any one of a sputtering method, an ion plating method, and a thermal evaporation method using an electron (e) gun. Here, although an indium-tin oxide electrode having transparency is used as the first electrode 130 according to the embodiment of the present invention, an indium-zinc oxide electrode having transparency may be used.

The second electrode 150, which is opposite to the first electrode 130, is commonly referred to as an upper electrode, and is formed on the organic layer 170. The second electrode 150 is a cathode, that is, a negative (-) electrode, which is the opposite of the first electrode 130, that is, the positive electrode. The second electrode 150 is made of any one selected from a group consisting of silver (Ag), aluminum (Al), and a magnesium-silver (Mg-Ag) alloy having transparency.

The organic layer 170 is interposed between the first electrode 130 and the second electrode 150, and emits light using electrical conduction between the first electrode 130 and the second electrode 150. The organic layer 170 includes a Hole Injection Layer (HIL) 172, a Hole Transporting Layer (HTL) 174, an EMissive Layer (EML) 176, an Electron Transporting Layer (ETL) 178, and an Electron Injection Layer (EIL) 179 so that the organic layer 170 can emit light using the electrical conduction between the first electrode 130 and the second electrode 150.

Here, the organic layer 170 is interposed between the first electrode 130 and the second electrode 150 using any one of a spin coating method, a thermal evaporation method, a spin casting method, a sputtering method, an electron (e)-beam evaporation method, and a Chemical Vapor Deposition (CVD) method.

The hole injection layer 172 functions to enable holes to be injected from the first electrode 130, and the hole transporting layer 174 functions as the movement path of holes injected from the hole injection layer 172 so that the injected holes can meet the electrons from the second electrode 150.

The electron injection layer 179 functions to enable electrons to be injected from the second electrode 150, and the electron transporting layer 178 functions as the movement path of electrons injected from the electron injection layer 179 so that the injected electrons meet the holes moving from the hole transporting layer 174, in the emissive layer 176.

In order to facilitate the injection of electrons from the second electrode 150, the electron transporting layer 178 may be doped with any one selected from the group consisting of low-work-function metals and mixtures thereof, which can be applied regardless of the existence of the electron injection layer 179.

Here, the low-work-function metals may include Cs, Li, Na, K, and Ca, and the mixtures thereof may include Li-Al, LiF, CsF, and Cs₂CO₃.

Meanwhile, the emissive layer 176 is interposed between the hole transporting layer 174 and the electron transporting layer 178, and emits light using the holes from the hole transporting layer 174 and the electrons from the electron transporting layer 178. That is, the emissive layer 176 emits light using the holes and the electrons which meet on the boundary surface between the hole transporting layer 174 and the electron transporting layer 178.

The transparent layer 190 may be formed between the organic layer 170 and the second electrode 150 and/or on the second electrode 150. For example, the transparent layer 190 may be formed on both the top and bottom surfaces of the second electrode 150, or on the top or bottom surface of the second electrode 150.

Although this embodiment shows an example of a configuration in which the transparent layer 190 is formed on both the top and bottom surfaces of the second electrode 150, the present invention is not limited thereto, but a configuration in which the transparent layer 190 is formed on only the top or bottom surface of the second electrode 150 may be applied to the present invention.

The transparent layer 190 may include a first transparent layer 191 formed between the organic layer 170 and the second electrode 150 and a second transparent layer 192 formed on the top surface of the second electrode 150.

Preferably, the first transparent layer 191 may be formed between the electron injection layer 179 and second electrode 150 of the organic layer 170, or may be formed in the electron injection layer 179 itself. Furthermore, the second transparent layer 192 may be placed on the top surface of the second electrode 150 which faces the first transparent layer 191.

Here, the transparent layer 190 functions to enable the second electrode 150 to have both transparency and high transmittance. Furthermore, the transparent layer 190 is configured in the form of a thin film, and thus reduces the surface resistance of the second electrode 150, thereby preventing the performance of the TOLED panel from being deteriorated. The characteristics of the transparent layer 190 will be described in detail with reference to FIGS. 13 to 15 after oxides, nitrides, salts, and mixtures thereof have been described.

The transparent layer 190 according to the present invention may include any one selected from the group consisting of oxides, nitrides, salts and mixtures thereof.

Here, the oxides may include MoO₃, ITO, IZO, IO, ZnO, TO, TiO₂, SiO₂, WO₃, Al₂O₃, Cr₂O₃, TeO₂ and SrO₂. Furthermore, the nitrides may include Si₃N₄ and AIN. Furthermore, the salts may include Cs₂CO₃, Li₂CO₃, K₂CO₃, Na₂CO₃, LiF, CsF and ZnSe.

Although it is preferable to use the oxide, nitride, salts or the mixture thereof in the transparent layer 190 because excellent transmittance and luminance can be exhibited, as shown in FIGS. 13 to 15, any material, other than those materials, may be used as long as the material enables the second electrode 150 to have both transparency and high transmittance.

Although the first transparent layer 191 and second transparent layer 192 of the transparent layer 190 are made of the same material, they may be made of different materials. For example, the first transparent layer 191 may include an oxide, and the second transparent layer 192 may include a nitride, a salt, and or a mixture thereof. Alternatively, the first transparent layer 191 may include a nitride, and the second transparent layer 192 may include any one selected from the group consisting of oxides, salts, and mixtures thereof. Alternatively, the first transparent layer 191 may include a salt, and the second transparent layer 192 may include an oxide, a nitride or a mixture thereof.

It is preferable that the thickness of the transparent layer 190 be equal to or greater than 0.1 nm and less than 100 nm. The reason for limiting the thickness of the transparent layer 190 is, for example, that when the thickness of the transparent layer 190 is less than 0.1 nm, the transmittance increases and the resistance also increases in proportion thereto, so that the performance of the TOLED panel is deteriorated.

In contrast, when the thickness of the transparent layer 190 is equal to or greater than 100 nm, the performance is not deteriorated due to decrease in resistance, but the transmittance decreases due to increase in the thickness of the transparent layer 190. Meanwhile, it is preferred that the transparent layer 190 according to the embodiment of the present invention be formed using thermal evaporation.

The characteristics of the TOLED panel having the above-described configuration according to the present invention will be described.

FIG. 13 is a graph showing transmittance depending on whether the transparent layer 190 is present in the TOLED panel according to the present invention. Here, in FIG. 13, 'a' denotes a curve for a TOLED panel with the transparent layer 190 according to the present invention, and 'b' denotes a curve for a TOLED panel without the transparent layer 190, which is different from that of the present invention.

The TOLED panel according to the present invention may exhibit a transmittance ranging from 70 to 99% depending on the wavelength (nm). For example, as shown in FIG. 13, with regard to the transmittance depending on the wavelength (nm), the TOLED panel according to the present invention exhibits a transmittance of about 80% at a wavelength of 550 nm, while the TOLED panel without the transparent layer 190 exhibits a transmittance of about 47%. From these results, it can be seen that the transmittance of the TOLED panel with the transparent layer 90 is 1.7 times as high as that of the TOLED panel without the transparent layer 190.

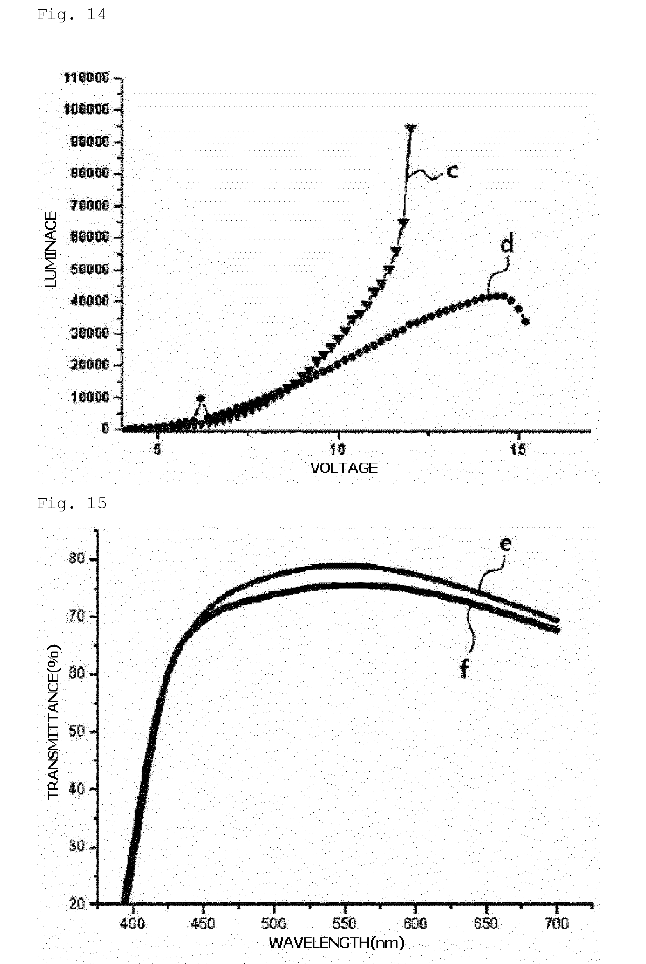

FIG. 14 is a graph showing luminance depending on whether the transparent layer 190 is present in the TOLED panel. In FIG. 14, 'c' denotes a curve for the TOLED panel according to the present invention, and 'd' denotes a curve for the TOLED panel without the transparent layer 190.

With regard to the luminance depending on a voltage of 10 V, the TOLED panel with the transparent layer 190 exhibits about 25000 while the TOLED panel without the transparent layer 190 exhibits about 20000. Accordingly, it can be seen that there is a 1.25 times difference in the luminance depending on whether the transparent layer 190 is present.

In FIG. 15, curve 'e' shows transmittance for the transparent layer 190 made of an oxide, such as MoO₃, ITO, IZO, IO, ZnO, TO, TiO₂, SiO₂, WO₃, Al₂O₃, Cr₂O₃, TeO₂, or SrO₂, and curve 'f' shows transmittance for the transparent layer 190 made of a salt, such as Cs₂CO₃, Li₂CO₃, K₂CO₃, Na₂CO₃, LiF, CsF, or ZnSe.

As shown in FIG. 15, a transmittance of about 80% is obtained when the transparent layer 190 is made of an oxide, while a transmittance of about 75% is obtained when the transparent layer 190 is made of a salt. Although the transmittance for the transparent layer 190 made of an oxide is 5% higher than that for the transparent layer 190 made of a salt, this is merely a small difference, so that it may be preferable to selectively use an oxide, a salt and a mixture thereof, as in the embodiment of the present invention.

Therefore, since a TOLED panel is used as any one of display panels of a dual display panel, the display device can be slim and compact.

Further, each of the display panels of the dual display panel includes a touch panel, and the display panels are connected to be mutually moved, so that different information can be displayed on the respective display panels, thereby increasing the use of the product.

Furthermore, information is separately displayed on different display panels depending on the superimposed position and non-superimposed position of the dual display panel, thereby increasing the use of the product.

Furthermore, the transparent layer 190 is formed with the second electrode 150 of the TOLED panel disposed therein, so that double-sided light emission can be realized and transmittance can be improved.

Further, the transparent layer 150 may be formed to adjust the thickness of the second electrode 120, so that the transmittance and the electrical performance can be improved.

## Claims

1. A display device comprising:
a first display panel configured to display first information;
a second display panel selectively placed in a superimposed position, in which the second display panel is superimposed on the first display panel, and in a non-superimposed position, in which the second display panel is not superimposed on the first display panel, and configured to display second information;
a first touch panel disposed on the first display panel;
one or more second touch panels disposed on the second display panel or disposed on both side surfaces of the second display panel in pairs; and
a control unit configured to apply driving voltage to at least one of the first and second display panels based on a signal detected from at least one of the first and second touch panels depending on any one of the superimposed position and the non-superimposed position of the first and second display panels.

2. The display device according to claim 1, wherein the first display panel comprises any one of a Liquid Crystal Display (LCD) panel and Electronic-paper (E-Paper).

3. The display device according to claim 1, wherein the first display panel comprises an Organic Light-Emitting Diode (OLED) panel.

4. The display device according to claim 1, wherein the second display panel comprises an OLED panel.

5. The display device according to claim 3 or 4, wherein the OLED panel comprises a Transparent Organic Light-Emitting Diode (TOLED) panel.

6. The display device according to claim 5, wherein the TOLED panel comprises:
a substrate;
a first electrode formed on the substrate;
an organic layer formed on the first electrode;
a second electrode formed on the organic layer; and
a transparent layer formed between the organic layer and the second electrode and/or on the second electrode, and configured to include any one selected from a group consisting of oxides, nitrides, salts, and mixtures thereof.

7. The display device according to claim 6, wherein the oxides comprise MoO₃, ITO, IZO, IO, ZnO, TO, TiO₂, SiO₂, WO₃, Al₂O₃, Cr₂O₃, TeO₂ and SrO₂.

8. The display device according to claim 6, wherein the nitrides comprise Si₃N₄ and AIN.

9. The display device according to claim 6, wherein the salts comprise Cs₂CO₃, Li₂CO₃, K₂CO₃, Na₂CO₃, LiF, CsF, and ZnSe.

10. The display device according to claim 6, wherein a thickness of the transparent layer is equal to or greater than 0.1 nm and less than 100 nm.

11. The display device according to claim 6, wherein the organic layer comprises an electron transporting layer doped with any one selected from a group consisting of low-work-function metals and mixtures thereof in order to facilitate injection of electrons from the second electrode.

12. The display device according to claim 11, wherein the low-work-function metals comprise Cs, Li, Na, K, and Ca.

13. The display device according to claim 11, wherein the mixtures thereof comprise Li-Al, LiF, CsF, and Cs₂CO₃.

14. The display device according to claim 6, wherein the TOLED panel exhibits a transmittance ranging from 70 to 99% depending on wavelength (nm).

15. The display device according to claim 1, wherein the second display panel moves on the first display panel in a sliding manner between the superimposed position and the non-superimposed position.

16. The display device according to claim 1, wherein the second display panel moves relative to the first display panel in a rotating manner between the superimposed position and the non-superimposed position.

17. The display device according to claim 1, wherein the control unit applies the driving voltage to the first display panel based on the signal detected from the second touch panel when the first and second display panels are placed in the superimposed position.

18. The display device according to claim 1, wherein the control unit applies the driving voltage to the first display panel based on the signal detected from the first touch panel and applies the driving voltage to the second display panel based on the signal detected from the second touch panel when the first and second display panels are placed in the non-superimposed position.

19. The display device according to claim 1, further comprising a brightness measurement sensor for detecting intensity of an outside illumination,
wherein the control unit controls the driving voltage based on a signal detected from the brightness measurement sensor so that brightness of any one of the first and second display panels is adjusted.

20. A display device comprising:
a first display panel configured to display first information;
a second display panel selectively placed in a superimposed position, in which the second display panel is superimposed on the first display panel, and a non-superimposed position, in which the second display panel is not superimposed on the first display panel, and configured to display second information;
a touch panel disposed on the second display panel; and
a control unit configured to, when the first and the second display panels are placed in any one of the superimposed position and the non-superimposed position, selectively apply driving voltage to the first and second display panels based on a signal detected from the touch panel.

21. The display device according to claim 20, wherein:
the first display panel comprises any one of an OLED panel, an LCD panel, and E-Paper; and
the second display panel comprises the OLED panel.

22. The display device according to claim 21, wherein the OLED panel comprises a TOLED panel.

23. The display device according to claim 20, wherein the second display panel moves on the first display panel in a sliding manner between the superimposed position and the non-superimposed position.

24. The display device according to claim 20, wherein the second display panel moves relative to the first display panel in a rotating manner between the superimposed position and the non-superimposed position.

25. The display device according to claim 20, wherein the control unit applies the driving voltage to the first display panel based on the signal detected from the touch panel when the first and second display panels are placed in the superimposed position.

26. The display device according to claim 20, wherein the control unit applies the driving voltage to the second display panel based on the signal detected from the touch panel when the first and second display panels are placed in the non-superimposed position.

27. The display device according to claim 20, further comprising a brightness measurement sensor for detecting intensity of an outside illumination,
wherein the control unit controls the driving voltage based on a signal detected from the brightness measurement sensor so that brightness of at least any one of the first and second display panels is adjusted.

28. A display device comprising:
a first display panel configured to display first information;
a second display panel selectively placed in a superimposed position, in which the second display panel is superimposed on the first display panel, and a non-superimposed position, in which the second display panel is not superimposed on the first display panel, and configured to display second information;
a first touch panel disposed on the first display panel;
a second touch panel disposed on one surface of the second display panel which is rotated relatively to the first touch panel; and
a control unit configured to selectively apply driving voltage to the first and second display panels based on a signal detected from the first or second touch panels.

29. The display device according to claim 28, wherein:
the first display panel comprises any one of an OLED panel, an LCD panel, and E-paper; and
the second display panel comprises the OLED panel.

30. The display device according to claim 29, wherein the OLED panel comprises a TOLED panel.

31. The display device according to claim 28, wherein the second display panel moves on the first display panel in a sliding manner between the superimposed position and the non-superimposed position.

32. The display device according to claim 28, wherein the second display panel moves relative to the first display panel in a rotating manner between the superimposed position and the non-superimposed position.

33. The display device according to claim 28, wherein the control unit applies the driving voltage to the first display panel based on the signal detected from the first touch panel and applies the driving voltage to the second display panel based on the signal detected from the second touch panel when the first and second display panels are placed in the non-superimposed position.

34. The display device according to claim 20, further comprising a brightness measurement sensor for detecting intensity of an outside illumination,
wherein the control unit controls the driving voltage based on a signal detected from the brightness measurement sensor so that brightness of any one of the first and second display panels is adjusted.
